Europäisches Patentamt

European Patent Office

Office européen des brevets

(19)

(11) Publication number: **0 211 603**
B1

(12) **EUROPEAN PATENT SPECIFICATION**

(45) Date of publication of the patent specification:
18.10.89

(21) Application number: 86305830.1

(22) Date of filing: 29.07.86

(51) Int. Cl.⁴: **H01B 3/12**, H01G 4/12,
C04B 35/00

(54) Method of making ceramic dielectric bodies.

(30) Priority: 07.08.85 US 763388

(43) Date of publication of application:
25.02.87 Bulletin 87/9

(45) Publication of the grant of the patent:
18.10.89 Bulletin 89/42

(84) Designated Contracting States:
BE DE FR GB

(56) References cited:
DE-B- 1 464 417
GB-A- 926 292

(73) Proprietor: SPRAGUE ELECTRIC COMPANY,
96 Marshall Street, North Adams
Massachusetts 01247(US)

(72) Inventor: Maher, Galeb Hamid, 116 Autumn Drive, North
Adams Massachusetts 01247(US)

(74) Representative: Spencer, Graham Easdale et al, A.A.
Thornton & CO Northumberland House 303-306, High
Holborn, London WC1V 7LE(GB)

## Description

This invention is concerned with a method of making ceramic dielectric bodies which are suitable for use in laminar electrical components, such as wafer capacitors, multi-dielectric layer capacitors, and printed circuit assemblies.

It is known to make dielectric ceramic bodies from mixtures of a major proportion of a high firing ceramic and a minor proportion of a borate flux, such materials being described, for example, in U.S. Patents 3,885,941, 4,027,209, 4,101,952 and 4,308,570. The borate fluxes used as sintering aids in the prior art (with the exception of U.S. Patent 4,533,974) are glasses rather than being crystalline and they have melting temperatures which are less than the characteristic minimum sintering temperature of the high firing ceramic with which they are mixed.

The addition of such low melting glass fluxes reduces the temperature necessary for sintering by providing a vehicle for a liquid phase sintering mechanism. The only exception to this type of process known to us is the use of crystalline cadmium silicates as described in U.S. Patent 4,266,265. This flux is not, of course, a borate and the patent contains no disclosure or suggestion as to the use of crystalline borates as a sintering aid or flux.

We have now found that magnesium orthoborate ($Mg_3B_2O_6$), which is one of several sintering aids described in U.S. Patent 4,533,974, provides exceptional dielectrical properties when employed as the predominant crystalline constituent of a ceramic dielectric body in a laminar electrical component such as a wafer capacitor, a monolithic capacitor, or a printed wiring substrate. The ceramic material is very dense, has high Q and high frequency characteristics, and has a low dielectric constant.

It is also capable of being "fluxed" with high melting materials such as barium oxide. Reaction of the boron in the magnesium orthoborate in a limited surface reaction with the "flux" produces eutectic which leads to liquid phase sintering at temperatures well below the melting point of either the "flux" or the magnesium orthoborate. For no other high firing dielectric than magnesium orthoborate is this known to be true.

Furthermore, the compound of central interest here, magnesium orthoborate, is a very obscure material. Except for its having received academic attention as one of the three single-phase magnesium borates, it has apparently found no use.

According to the present invention, therefore, there is provided a method of making a ceramic dielectric body suitable for use in a laminar electrical component, which comprises

(a) mixing a ceramic powder containing from 85 to 100 mole % of magnesium orthoborate ($Mg_3B_2O_6$) and a suitable liquid carrier to form a slurry,
(b) forming a layer of the slurry from step (a) and drying the layer,
(c) depositing a film of an electroding ink on at least a part of the surface of the dry layer from step (b), and

(d) firing the coated layer from step (c) at such a temperature that the ceramic material is sintered to give a dense ceramic layer and the electroding ink is sintered to form a conductive film adhering to the ceramic layer.

In a modification of this method, the dried ceramic layer (from step (b) above) is first sintered to form a dense ceramic layer, the electroding ink is deposited on the ceramic layer, and the coated ceramic layer is then re-sintered to sinter the electroding ink and form a conductive film thereof adhering to the ceramic layer.

The final assembly may form the nucleus for numerous laminar electronic components such as ceramic wafer capacitors, monolithic ceramic capacitors, and printed circuit boards.

Magnesium orthoborate possesses a unique combination of properties that can lead to high performance electrical components. Briefly, the dielectric constant (7.2) of magnesium orthoborate is quite low, making it possible to build small capacity capacitors to tight tolerances, and in printed circuit substrates reduces interwiring capacitances. This feature is combined with a high Q (low DF) at very high frequencies, a high density and a high bond strength with adjacent co-fired ceramics of different composition which gives great versatility of design in multi-layer printed wiring substrates. It is also capable of being fired in air or co-fired with buried base metal electrodes, such as those of copper or nickel.

In order that the invention may be more fully understood, the following Examples are given by way of illustration. Reference will be made in the Examples to the accompanying drawings, in which:

Figure 1 is a side sectional view of a wafer capacitor having a dominantly magnesium orthoborate ceramic body;

Figure 2 shows in side sectional view a monolithic ceramic capacitor having a dominantly magnesium orthoborate ceramic body;

Figure 3 shows in side sectional view a printed circuit substrate habing a body that is primarily a magnesium orthoborate-containing ceramic, and

Figure 4 shows a multilayer ceramic printed circuit assembly having a plurality of strata, some of which are formed primarily of magnesium orthoborate, and having a silicon integrated circuit chip connected thereto.

## Example 1

Magnesium orthoborate was prepared by milling boric acid and magnesium carbonate. The two compounds were milled together in acetone and then dried, calcined at 1200°C and comminuted to form a powder of $Mg_3B_2O_6$, as confirmed by X-ray diffraction analysis. The powder had an orthohombic crystal structure with an X-ray theoretical ultimate density of 3.10 g/cm³.

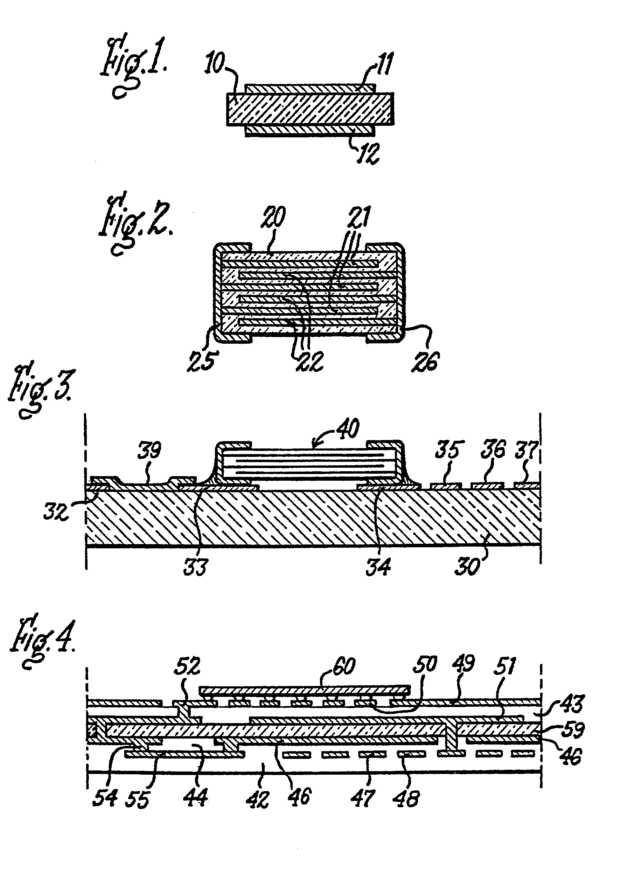

A number of experimental wafer type capacitors were made, as shown in Figure 1. The wafer bodies were first formed by the conventional steps of wet milling a start powder for about two hours and drying. The start powder in this example consisted of the $Mg_3B_2O_6$ referred to above. This was crushed and jet pulverised to an average particle size of about 1 to 1.5 μm. The fine powder was combined in an organic vehicle and cast squares (about 1 cm²) were formed to about 0.6 mm thickness.

## Examples 2 and 3

One group of these cast squares (Example 2) was sintered in air at 1200°C, while another group (Example 3) was sintered in an environment having a partial oxygen pressure of $10^{-9}$ atmospheres of oxygen at 1200°C. A silver electroding paste was applied to the two major faces of each mature ceramic cast square, or wafer, and the wafers were fired at 800°C to form wafer capacitors each having bodies 10 and electrodes 11 and 12, as shown in Figure 1.

The wafer capacitors from the groups of Examples 2 and 3 were essentially identical: namely, milky white in colour, exhibiting an unusually high density of 97% of that theoretically possible, a dielectric constant of 7.2, and at 1 MHz and 25°C the DF was less than 0.01%.

## Example 4

Another portion of the calcined $Mg_3B_2O_6$ powder obtained in Example 1 was combined with an organic vehicle to form a slurry that was repeatedly deposited in 5 mil (0.13 mm) thick layer, each layer being dried and having an electroding ink film of 10Ag/90Pd deposited thereon prior to deposition of the next slurry layer. The last three or topmost slurry layers and the first three slurry layers were not coated with the electroding ink. There were six electrode films with five active dielectric layers therebetween. This assembly was sintered at 1200°C for 2¼ hours to drive off all the organic materials from both the ink and the slurry layers, and to alloy the metal to 10Ag/90Pd alloy film electrodes buried in a sintered dielectric block 20 of $Mg_3B_2O_6$. In this way, a monolithic ceramic capacitor was formed, as shown in Figure 2, in which left-end extending buried electrodes 21 and right-end extending buried electrodes 22 are contacted at the left and right ends respectively by silver terminations 25 and 26.

The density of the ceramic was 97.2% of theoretical and the dielectric constant was 7.2. These monolithic capacitors had a higher capacitance, viz. 32 pF, than the wafer capacitors obtained in Examples 2 and 3 and consequently it was possible to measure the DF at 10 KHz and at 100KHz. At 100 KHz the DF was 0.05% and at 1 MHz it remained at less than 0.01%. The temperature coefficient of capacitance was a positive 100 parts per million (P 100ppm/°C) at -55°C and was P 150ppm/°C at +115°C.

Various other wafer capacitors were made by the conventional method steps described above, employing as the start powder the $Mg_3B_2O_6$ powder of Example 1 to which was added a small quantity of one of two other powder compounds.

## Examples 5, 7 and 9

Dielectric bodies were prepared containing various amounts of baria and manganese carbonate, and were sintered in a non-oxidising atmosphere at 1100°C to a very dense mature ceramic. The dielectric constant was raised about 10%. The addition in Example 5 of 3.7 mole % of baria without manganese carbonate gave about optimum results, i.e. the sintering temperature reduction amounted to about 50°C and the DF remained extremely low.

## Examples 6, 8 and 10

These Examples were the same as Examples 5, 7 and 9 respectively except for being sintered in air and the results were very similar.

## Example 11

The additive in this Example was zinc cadmium borate, $2ZnO.CdO.B_2O_3$. (Note that this compound expression is in mole % of the constituent oxides.) This material has been used as a flux additive in other dielectric ceramic bodies for reducing sintering temperature. In this instance, however, it is clearly not as satisfactory as baria. Although the DF was quite low, the density of the body was comparatively low and the sintering temperature was reduced less for the same amounts of additive.

## Examples 12 to 17

Various (molar) amounts of lithium oxide were added to the magnesium borate. The lithium was actually added as lithium carbonate. By sintering a few wafers of each composition at temperatures in 50°C intervals, the minimum sintering temperatures of each composition were determined.

The efficiency of the lithium additive to reduce the sintering temperature was greatest in Example 13 at the 3 mole % level. The DF remained essentially unaffected except in Example 14, where sintering was effected in a partial oxygen atmosphere and achieved nearly the same density by slightly sacrificing DF.

## Example 18

Using the same 3 mole % $Li_2O$ composition as used in Examples 13 and 14, a monolithic ceramic capacitor was built having five buried electrodes, four "active" 6 mil (0.15 mm) thick dielectric layers, and having a total capacitance of 32 PF. The buried electrodes were made of the industry-standard electroding alloy 70Ag/30Pd. The dielectric constant was 7.2, DF at 1 MHz and was less than 0.01%, the temperature coefficient of capacitance averaged 75 ppm/°C over the temperature range -55°C to +125°C, and insulation resistance at 200 volts and 150°C was more than $10^6$ megohms.

Additional measurements of Q were made by a transmission-line method. At 200 MHz, the Q was 150; at 400 MHz, the Q was found to be about 100, which is equivalent to a DF of 0.01.

### Example 19

Another monolithic ceramic capacitor was made by exactly the same process as were the monolithic capacitors of Example 18, except that a 95Ag/5Pd (by weight) silverrich alloy was used instead of the 70Ag/30Pd alloy. For this capacitor, the Q at 200 MHz was 4000 and at 400 MHz was 350. This demonstrates that at high frequencies, the resistance of the buried electrodes, and not the dielectric, tend to become the dominant factor affecting the capacitor losses.

Measurements have been made of some of the material properties of magnesium orthoborate, with and without a flux (3% lithium oxide); the ceramics were sintered in air at 1200°C and 1050°C respectively.

Some of these properties are similar to those of the dense alumina bodies that are used as printed circuit substrates and multilayer circuit boards. For example, the thermal coefficient of expansion is about the same, as is the temperature coefficient of capacitance. However, the magnesium borates of this invention have characteristics that offer significant advantages for these applications.

The sintering temperatures of the magnesium orthoborate dielectrics is substantially lower than the minimum sintering temperature for alumina, namely about 1450°C. This advantage increases the number of materials which do not melt on co-firing with the ceramic, and a much greater variety of electroding the resistor body metals may be buried in a ceramic multilayer circuit board. Another method for making magnesium orthoborate, that utilizes a technique of charring a dried emulsion, produces powders that are very fine and tend to sinter at lower temperatures without flux, and are expected to make strong low-firing substrates. It has also been discovered that although the magnesium and boron oxide precursors are hygroscopic, magnesium orthoborate is not, a very important feature in a dielectric ceramic.

The dielectric constant of alumina is 9, about 26% higher than that of the magnesium orthoborate ceramic. This leads to a commensurate reduction in the interwiring capacitances of equal dimensional printed circuit substrates and multilayer circuit boards made with magnesium orthoborate ceramics. Alternatively, the latter may be reduced in size before the interwiring capacitances reach the values exhibited by conventional alumina counterparts.

Referring to Figure 3, a printed circuit substrate 10 made of a magnesium orthoborate material has a plurality of film conductors 32, 33, 34, 35, 36 and 37 formed by screen printing thereon. These conductors may be deposited before or after the sintering of the ceramic substrate. A high resistivity film 39 may be one such as is described in U.S. Patent 3,989,874. A monolithic ceramic capacitor 40, similar to that of Figure 2, is shown solder-mounted to conductors 33 and 34.

Figure 4 shows a multilayer ceramic printed circuit board made up of magnesium orthoborate material regions, e.g. 42, 43 and 44, that are shown as unhatched areas; metal conductors, e.g. 46, 47, 48, 49, 50, 51 and 52; a high resisitivity resistor film 55; and a high dielectric constant ceramic material 59, e.g. a lead barium lanthanum zirconate titanate such as described in U.S. Patent 4,324,750. The material of Example 7 of the U.S. Patent was used, which has a dielectric constant of over 1800, to give a buried capacitor having a high capacitance value between conductors 46 and 51. The interwiring capacitance between other conductors, e.g. 51 and 49, had very low values. The conductive vias, e.g. 54 may be made by standard techniques of punching holes in the green ceramic layers and later filling them with metal. A silicon integrated circuit chip 60 is shown face-bonded directly to the conductors, e.g. 49, 50 and 52. The face bonding may be accomplished by conventional means such as heating to reflow solder-bond solder bumps to the substrate conductors or by ultrasonically energising the assembly.

### Example 20

Some of the magnesium orthoborate slurry used to make the monolithic ceramic capacitors of Example 18 was cast on a plate using the doctor blade technique, and dried. 70Ag/30Pd electroding ink was printed on a surface of the dried slurry layer. Subsequently, a 1 mil (0.02 mm) slurry layer of the lead barium lanthanum zirconate titanate referred to above was formed by the same technique over the printed surface, and dried. Again, a printed electroding ink layer was formed and a top layer of magnesium borate slurry was deposited thereon to form a sandwich about the two titanate electrode layers. This assembly was sintered at 1050°C in air. The sintered sandwich was sectioned and observed under a microscope. There was complete bonding of the adjacent layers with no evidence of separation or delamination at any point.

Example 20 demonstrates the ability of magnesium orthoborate to co-fire with and bond well to other ceramic materials. It is, therefore, a demonstration of the basic feasibility of multi-layer circuits like that shown in Figure 4.

### Claims

1. A method of making a ceramic dielectric body suitable for use in a laminar electrical component, which comprises

   (a) mixing a ceramic powder containing from 85 to 100 mole % of magnesium orthoborate ($Mg_3B_2O_6$) and a suitable liquid carrier to form a slurry,

   (b) forming a layer of the slurry from step (a) and drying the layer,

   (c) depositing a film of an electroding ink on at least a part of the surface of the dry layer from step (b), and

   (d) firing the coated layer from step (c) at such a temperature that the ceramic material is sintered to give a dense ceramic layer and the electroding ink is sintered to form a conductive film adhering to the ceramic layer.

2. A modification of the method according to claim 1, in which the dry layer from step (b) is sintered to give a dense ceramic layer, a film of an eletroding ink is deposited on at least part of the surface of the ceramic layer, and the coated ceramic layer is resintered at such a temperature that the electroding ink is sintered to form a conductive film adhering to the ceramic layer.

3. A method according to claim 1 or 2, in which the ceramic powder used in step (a) contains up to 15 mole % of a sintering aid.

4. A method according to claim 3, in which the sintering aid is BaO or $Li_2O$.

5. A method according to any of claims 1 to 4, in which the slurry formed in step (a) comprises an additional ceramic powder.

6. A method according to claim 4 or 5, in which the additional ceramic powder has a minimum sintering temperature of more than 1150°C.

7. A method according to any of claims 1 to 6, in which the conductive film adhering to the ceramic layer is in the form of one or more patches which are individually secured by means of permanent conductive connections to conductive bumps extending from one face of an integrated circuit chip.

8. A method according to any of claims 1 to 7, which further comprises mixing a powdered dielectric material with a suitable liquid carrier to form a second slurry and applying a layer of said slurry to the surface of the coated layer from step (c), drying said second layer, and sintering the resulting composite structure in one step to form a dense ceramic body having a conductive film within.

9. A method according to claim 8, in which the second slurry has the same composition as the slurry used in step (b) so that the resulting ceramic body has the same ceramic composition throughout.

10. A method according to claim 8, in which the second ceramic layer of the resulting ceramic body has a higher dielectric contant than the first ceramic layer.

11. A method according to any of claims 8 to 10, which further comprises depositing a second film of an electroding ink on at least a part of the surface of the dry second layer, and sintering the resulting composite structure in one step to form a dense ceramic body having a conductive film within and a conductive film on the surface.

12. A method according to claim 11, in which the two conductive films in the resulting ceramic body are so arranged that each film extends to and is exposed at a face of the body, the faces at which the films are exposed being on opposite sides of the body.

13. A method according to any of claims 1 to 12, in which the electroding ink comprises a metal in a carrier liquid and sintering of the deposited ink is carried out in a low partial oxygen atmosphere so that the metal is not oxidised.

14. A method according to claim 13, in which the metal is copper or nickel.

15. A laminar electrical component comprising a ceramic dielectric body made by the method claimed in any of the preceding claims.

**Patentansprüche**

1. Verfahren zum Herstellen eines zum Verwenden in einem laminaren elektrischen Bauteil geeigneten keramischen Dielektrikums, welches die folgenden Verfahrensschritte aufweist
   a) Vermischen eines 85-100 mol.–% Magnesium Orthoborat ($Mg_3B_2O_6$) enthaltenden keramischen Pulvers und einer geeigneten Flüssigkeitsträgersubstanz zum Bilden eines Schlammes,
   b) Ausbilden einer Schicht aus dem Schlamm gemäß Schritt a) und Trocknen der Schicht,
   c) Aufbringen eines Films einer elektrodischen Tinte auf wenigstens einen Teil der Oberläche der getrockneten Schicht von Schritt b), und
   d) Brennen der umgebenden Schicht gemäß Schritt c) bei einer solchen Temperatur, daß das keramische Material gesintert wird, um eine dichte keramische Schicht zu ergeben, und die elektrodische Tinte gesintert wird, um einen auf der keramischen Schicht aufgebrachten leitfähigen Film zu bilden.

2. Abwandlung des Verfahrens nach Anspruch 1, bei der die getrocknete Schicht gemäß Schritt b) gesintert wird, um eine dichte keramische Schicht zu ergeben, ein Film einer elektrodischen Tinte auf wenigstens einem Teil der Oberfläche der keramischen Schicht aufgebracht wird und die umgebenden keramische Schicht bei einer solchen Temperatur nachgesintert wird, daß die elektrodische Tinte gesintert wird, um einen auf der keramischen Schicht aufgebrachten leitfähigen Film zu bilden.

3. Verfahren nach Anspruch 1 oder 2, bei welchem das in Schritt a) verwendete keramische Pulver bis zu 15 mol.–% eines Sinterhilfsmittels enthält.

4. Verfahren nach Anspruch 3, bei welchem das Sinterhilfsmittel BaO oder $Li_2O$ ist.

5. Verfahren nach einem der Ansprüche 1 bis 4, bei welchem der in Schritt a) gebildete Schlamm ein zusätzliches keramisches Pulver aufweist.

6. Verfahren nach Anspruch 4 oder 5, bei welchem das zusätzliche keramische Pulver eine minimale Sintertemperatur von mehr als 1150°C hat.

7. Verfahren nach einem der Ansprüche 1 bis 6, bei welchem der auf der keramischen Schicht aufgebrachte leitfähige Film in Form einer oder mehrerer Flicken gebildet ist, die jeweils mittels permanent leitfähigen Verbindungen an leitfähigen Vorsprüngen befestigt sind, die von einer Oberfläche eines integrierten Schaltungschips vorstehen.

8. Verfahren nach einem der Ansprüche 1 bis 7, welches ferner umfaßt, Vermischen eines pulverförmigen dielektrischen Materials mit einer geeigneten Flüssigkeitsträgersubstanz, zum einen zweiten Schlamm zu bilden, und Aufbringen einer Schicht aus diesem Schlamm auf die Oberfläche der umgebenden Schicht gemäß Schritt c), Trocknen der zweiten Schicht und Sintern des sich ergebenden zusammengesetzten Gefüges in einem Schritt, um einen dichten Keramikkörper mit einem innenliegenden leitfähigen Film zu bilden.

9. Verfahren nach Anspruch 8, bei welchem der zweite Schlamm dieselbe Zusammensetzung wie der in Schritt b) verwendete Schlamm aufweist, so daß der sich ergebende keramische Körper im Ganzen dieselbe keramische Zusammensetzung hat.

10. Verfahren nach Anspruch 8, bei welchem die zweite Keramikschicht des sich ergebenden keramischen Körpers eine höhere Dielektrizitätskonstante als die erste keramische Schicht hat.

11. Verfahren nach einem der Ansprüche 8 bis 10, welches ferner umfaßt, Aufbringen eines zweiten Films einer elektrodischen Tinte auf wenigstens einen Teil der Oberfläche der getrockneten zweiten Schicht und Sintern des sich ergebenden zusammengesetzten Gefüges in einem Schritt, um einen dichten keramischen Körper zu bilden, der einen innenliegenden leitfähigen Film und auf der Oberfläche einen leitfähigen Film aufweist.

12. Verfahren nach Anspruch 11, bei welchem die zwei leitfähigen Filme in dem sich ergebenden Keramikkörper so angeordnet sind, daß jeder Film sich auf eine Oberfläche des Körpers hin erstreckt und dieser gegenüber angeordnet ist, wobei die Oberflächen, denen gegenüber die Filme angeordnet sind, an gegenüberliegenden Seiten des Körpers angeordnet sind.

13. Verfahren nach einem der Ansprüche 1 bis 12, bei welchem die elektrodische Tinte ein Metall in einer Trägerflüssigkeit aufweist und das Sintern der aufgebrachten Tinte derart in einer niedrigen Partialsauerstoffgehalt aufweisenden Atmosphäre durchgeführt wird, daß das Metall nicht oxidiert.

14. Verfahren nach Anspruch 13, bei welchem das Metall Kupfer oder Nickel ist.

15. Laminares elektrisches Bauteil, welches ein keramisches Dielektrikum aufweist, das durch das in einem der vorstehenden Ansprüche beanspruchte Verfahren hergestellt ist.

**Revendications**

1. Un procédé de fabrication d'un corps diélectrique céramique utilisable dans un composant électrique stratifié, qui consiste:

(a) à mélanger une poudre céramique contenant de 85 à 100% molaire d'un orhoborate de magnésium (Mg₃B₂O₆) et un véhicule liquide approprié pour former une bouille,

(b) à former une couche de la bouillie provenant de l'étape (a) et à sécher la couche,

(c) à déposer un film d'une encre d'électrode sur au moins une partie de la surface de la couche séchée provenant de l'étape (b) et

(d) à cuire la couche revêtue provenant de l'étape (c) à une température tell que le matériau céramique est fritté pour donner une couche céramique dense et que l'encre d'électrode est frittée pour former un film conducteur adhérent à la couche céramique.

2. Une modification du procédé selon la revendication 1, selon laquelle la couche séchée de l'étape (b) est frittée pour donner une couche céramique dense, un film d'une encre d'électrode est déposé sur au moins une partie de la surface de la couche céramique, et la couche céramique revêtue est re-frittée à une température telle que l'encre d'élecrode est frittée pour former un film conducteur adhérent à la couche céramique.

3. Un procédé selon la revendication 1 ou 2 selon lequel la poudre céramique utilisée dans l'étape (a) contient jusqu'à 15% molaire d'un adjuvant de frittage.

4. Un procédé selon la revendication 3 selon lequel l'adjuvant de frittage est du BaO ou du Li₂O.

5. Un procédé selon l'une quelconque des revendication 1 à 4 selon lequel la bouillie formée dans l'étape (a) comprend une poudre céramique additionnelle.

6. Un procédé selon la revendication 4 ou 5 selon lequel la poudre céramique additionnelle a une température de frittage minimale supérieure à 1 150°C.

7. Un procédé selon l'une quelconque des revendications 1 à 6 selon lequel le film conducteur adhérent à la couche céramique est sous la forme d'une ou de plusieurs plages qui sont fixées individuellement au moyen de connexions conductrices permanentes à des bourrelets conducteurs d'étandant depuis une face d'une puce à circuits intégrés.

8. Un procédé selon l'une quelconque des revendications 1 à 7 qui consiste en outre à mélanger un matériau diélectrique en poudre avec un véhicule liquide approprié pour former une seconde bouillie et à appliquer une couche de cette bouillie à la surface de la couche revêtue provenant de l'étape (c) à sécher cette seconde couche, et à fritter la structure composite résultante en une étape pour former un corps céramique dense contenant un film conducteur.

9. Un procédé selon la revendication 8 selon lequel la seconde bouillie à la même composition que la bouillie utilisée dans l'étape (b) de sorte que le corps céramique résultant à la même composition céramique dans toute la masse.

10. Un procédé selon la revendication 8 selon lequel la seconde couche céramique du corps céramique résultant a une constante diélectrique supérieure à celle de la première couche céramique.

11. Un procédé selon l'une quelconque des revendications 8 à 10 qui consiste en outre à déposer un second film d'une encre d'électrode sur au moins une partie de la surface de la second couche séchée et à fritter la structure composite résultante en une étape pour former un corps céramique dense contenant un film conducteur et ayant un film conducteur sur sa surface.

12. Un procédé selon la revendication 11 selon lequel les deux films conducteurs dans le corps céramique résultant sont agencés de façon que chaque film s'étende et soit exposé à une face du corps, les faces sur lesquelles les films sont exposés étant sur les côtés opposés dudit corps.

13. Un procédé selon l'une quelconque des revendications 1 à 12 selon lequel l'encre d'électrode comprend un métal dans un véhicule liquide et le frittage de l'encre déposée est conduit dans une atmosphère à faible teneur partielle en oxygène de sorte que le métal n'est pas oxydé.

14. Un procédé selon la revendication 12 selon lequel le métal est du cuivre ou du nickel.

15. Un composant électrique stratifié comprenant un corps diélectrique céramique fabriqué par le procédé revendiqué dans l'une quelconque des revendications précédentes.

Fig.1.

Fig.2.

Fig.3.

Fig.4.